# FASCICULE DE BREVET EUROPEEN

(11) **EP 2 777 045 B1**
(45) Date de publication et mention de la délivrance du brevet: **06.09.2017**
(21) Numéro de dépôt: 12775242.6
(22) Date de dépôt: 18.10.2012
(51) Int. Cl.: G11C 5/14, G11C 11/412, G11C 11/417, G11C 11/4074, G11C 11/41, H03K 3/012, G11C 13/00

(54) **CIRCUIT DE POLARISATION ARRIERE D'INVERSEURS POUR REDUCTION DE LA CONSOMMATION D'UNE MÉMOIRE SRAM**
SCHALTUNGSANORDNUNG ZUR VORSPANNUNG DER INVERTERN-WANNEN ZUR REDUZIERUNG DES ENERGIEVERBRAUCHS EINES SRAMS
POLARISATION CIRCUIT OF INVERTERS WELLS REDUCING POWER CONSUMPTION OF AN SRAM

(30) Priorité: 07.11.2011 FR 1160085
(43) Date de publication de la demande: 17.09.2014
(73) Titulaire: Commissariat à l'Énergie Atomique et aux Énergies Alternatives, 75015 Paris (FR)
(72) Inventeur: THOMAS, Olivier, 38420 Revel (FR); MAKOSIEJ, Adam, 75012 Paris (FR); VLADIMIRESCU, Andrei, 75006 Paris (FR)
(74) Mandataire: Bréda, Jean-Marc
(86) Numéro de dépôt international: PCT/EP2012/070666
(87) Numéro de publication internationale: WO 2013/068221

(56) Documents cités:
- EP-A1- 1 684 299
- US-A- 5 874 851
- US-A1- 2003 080 802

## Description

L'invention concerne les circuits intégrés CMOS à très faible consommation, et notamment les mémoires volatiles SRAM.

Des circuits intégrés de plus en plus complexes sont utilisés dans des applications où la disponibilité d'énergie est très limitée. C'est le cas des téléphones portables, des ordinateurs de poche, et autres appareils électroniques alimentés par des batteries. Il est important de minimiser leur consommation par tous les moyens possibles si on veut disposer d'une autonomie de fonctionnement suffisante. Or, les circuits intégrés consomment d'autant plus de puissance qu'ils comportent un plus grand nombre de transistors, et on fait aujourd'hui des circuits intégrés comportant des centaines de millions, voire des milliards de transistors. Des mémoires volatiles de type SRAM sont en particulier utilisées dans ces appareils, et leur capacité peut atteindre des millions ou milliards de points-mémoire, chaque point mémoire ayant par exemple six transistors.

Les mémoires statiques SRAM doivent être alimentées en énergie même en dehors des moments d'utilisation pour pouvoir conserver leur contenu entre deux utilisations. Si l'alimentation est coupée, l'information mémorisée disparaît. Comme les phases de non-utilisation peuvent parfois être beaucoup plus longues que les phases d'utilisation, il faut faire tout spécialement attention à minimiser la consommation pendant les phases de non-utilisation.

De manière générale, il est courant de réduire la tension d'alimentation des circuits intégrés, et notamment des mémoires SRAM dans un mode de veille entre deux utilisations ; on rétablit ensuite la tension normale, permettant un fonctionnement actif de la mémoire en lecture ou écriture lorsqu'on veut à nouveau utiliser l'appareil. Mais il faut quand même conserver une tension d'alimentation suffisante en mode de veille pour garantir le maintien de l'information stockée en mémoire. La limite de cette méthode se trouve donc dans le choix d'une tension de veille bien adaptée, à la fois suffisamment faible pour limiter la consommation et suffisante pour garantir le maintien de l'information stockée.

On a également proposé de modifier les tensions de polarisation de face arrière du substrat de circuit intégré en fonction de l'utilisation plus ou moins active de l'appareil : mode normal, mode de veille, ou même mode de fonctionnement accéléré.

La publication de brevet US-2003-080802 décrit par ailleurs un circuit d'ajustement de polarisation de caisson en fonctionnement normal, destiné à optimiser d'abord la vitesse et secondairement les fuites de courant au repos, lesquelles peuvent être détériorées si la tension de polarisation de caisson est mal adaptée. Ce document décrit un circuit de polarisation d'inverseurs d'un circuit intégré fournissant respectivement une première et deuxième tension de polarisation arrière aux caissons des transistors NMOS et PMOS du circuit intégré. Ce circuit comprend un circuit de détection fournissant un signal de sortie dont la valeur dépend d'une troisième et de la deuxième tension de polarisation arrière respectives des transistors NMOS et PMOS du circuit de détection, un circuit de production d'impulsions d'incrémentation ou décrémentation commandé par ledit signal de sortie et un circuit d'intégration relié au circuit de production d'impulsions pour produire et faire varier progressivement par incréments en réponses aux impulsions la première et deuxième tension de polarisation arrière ainsi que la troisième tension de polarisation arrière de manière à faire évoluer inversement ledit signal de sortie. Ce document utilise un inverseur comme détecteur, cet inverseur ayant sa sortie rebouclée sur son entrée, et cet inverseur reçoit des tensions de polarisation spécifiques permettant son fonctionnement en tant que détecteur. Le circuit décrit dans cette publication ne permet pas une adaptation des tensions de polarisation lorsqu'on passe à une très faible tension d'alimentation en mode de veille ; il fonctionne pour une tension d'alimentation standard. On signale par ailleurs les documents US 5 874 851, décrivant la commutation d'alimentations du potentiel des caissons, et EP 1 684 299, décrivant une mise en veille de circuits de mémoire.

La présente invention vise à améliorer les possibilités de réduction de la consommation en mode de veille par une action adaptative sur la tension de polarisation arrière des caissons des transistors NMOS et PMOS qui composent les inverseurs utilisés dans le circuit.

L'invention s'applique donc à des circuits intégrés dont les transistors NMOS, formés dans des caissons ou au-dessus de caissons dopés de type P, et les transistors PMOS, formés dans des caissons ou au-dessus de caissons dopés de type N, reçoivent des tensions de polarisation arrière distinctes NBIAS et PBIAS. Un circuit de polarisation établit ces tensions de polarisation notamment sur les inverseurs à deux transistors d'une mémoire SRAM, à partir d'un réseau de détection qui comprend de nombreux transistors NMOS et PMOS ; le comportement moyen de ces transistors varie en fonction des tensions de polarisation, en raison du fait que ces tensions tendent à modifier les tensions de seuil de mise en conduction des transistors ; on agit sur les tensions de polarisation de manière à s'approcher d'un comportement optimal désiré. Le comportement optimal est de préférence un comportement dans lequel les transistors NMOS et PMOS sont équilibrés. Par transistors équilibrés, on entend le fait qu'une même tension de référence, de préférence égale à la moitié de la tension d'alimentation Varray des inverseurs qui sont à polariser, appliquée à la grille d'un transistor NMOS et appliquée à la grille d'un transistor PMOS tend à faire circuler des courants identiques dans les deux transistors.

Par conséquent, l'invention propose un circuit de polarisation des inverseurs d'un circuit intégré, chaque inverseur comprenant un transistor NMOS et un transistor PMOS alimentés par une tension d'alimentation Varray, avec des moyens pour appliquer une première tension de polarisation arrière NBIAS aux caissons des transistors NMOS et une deuxième tension de polarisation arrière PBIAS aux caissons des transistors PMOS, le circuit de polarisation selon l'invention fournissant ces tensions de polarisation et comprenant :
- un réseau de détection comprenant pluralité d' inverseurs montés en parallèle, les inverseurs étant alimentés par la tension d'alimentation Varray et polarisés par les deux tensions de polarisation arrière et recevant sur leur grilles une même tension de référence comprise entre 0 et la tension d'alimentation Varray des inverseurs, la sortie commune des inverseurs constituant la sortie du réseau de détection, cette sortie fournissant un signal logique dont la valeur dépend des tensions de polarisation arrière appliquées au réseau,
- un circuit de production d'impulsions d'incrémentation ou décrémentation, commandé en fonction de la tension de sortie du réseau de détection,
- et un circuit d'intégration relié au circuit de production d'impulsions, pour produire et faire varier progressivement par incréments en réponse à ces impulsions, la première tension de polarisation arrière NBIAS et la deuxième tension de polarisation arrière PBIAS dans un sens tendant à inverser le niveau du signal logique de sortie du réseau de détecteur.

La tension de référence appliquée à l'entrée des inverseurs du réseau de détection est de préférence Varray/2.

Un circuit de translation de niveau logique peut être interposé entre la sortie du réseau de détection et l'entrée du circuit de production d'impulsions.

Le circuit de production d'impulsions peut comprendre un amplificateur de détection et un circuit de contrôle, le circuit de contrôle comportant un circuit d'horloge produisant périodiquement un signal d'activation constitué par des impulsions brèves servant à l'activation de l'amplificateur de détection, l'amplificateur de détection recevant une tension issue du réseau de détection et agissant comme un comparateur par rapport à une tension de référence pour produire sur l'une de deux sorties (OUT1, OUT2), en fonction du résultat de la comparaison, une impulsion de commande.

Le circuit de contrôle reçoit les deux sorties de l'amplificateur de détection et il produit quatre signaux impulsionnels correspondants en fonction des résultats de la comparaison ; ces signaux constituent des impulsions d'incrémentation et de décrémentation des tensions NBIAS et BPIAS respectivement ; ces impulsions sont transmises respectivement à quatre circuits translateurs de niveau, deux premiers circuits translateurs de niveau convertissant deux des signaux impulsionnels dans une plage de tensions correspondant à une plage de variation de tension désirée pour la tension de polarisation PBIAS, et deux autres circuits translateurs de niveau convertissant les deux autres signaux impulsionnels dans une plage de tensions correspondant à une plage de variation de tension désirée pour la tension de polarisation NBIAS.

Le circuit d'intégration comprend de préférence un premier circuit pour produire la tension de polarisation PBIAS et un deuxième circuit pour produire la tension de polarisation NBIAS, le premier circuit recevant sur ses entrées les sorties de deux premiers circuits translateurs de niveau, et le deuxième circuit recevant sur ses entrées les sorties des deux autres circuits translateurs de niveau.

Le premier circuit et le deuxième circuits peuvent être réalisés très simplement à partir de deux transistors en série, un transistor PMOS et un transistor NMOS, qui reçoivent sur leurs grilles les sorties des circuits translateurs de niveau. Pour le premier circuit, l'ensemble de deux transistors en série est alimenté entre une tension basse (Vlow_P) et une tension haute (Vhigh_P) correspondant à la plage de tensions désirée pour la variation de la tension PBIAS. Pour le deuxième circuit, l'ensemble de transistors en série du deuxième circuit étant alimenté entre une tension basse (Vlow_N) et une tension haute (Vhigh_N) correspondant à la plage de tensions désirée pour la variation de la tension NBIAS. Dans les deux circuits, la tension de polarisation (PBIAS ou NBIAS) est fournie au point de jonction du transistor NMOS et du transistor PMOS.

En général (mais pas obligatoirement), le circuit de polarisation comprendra une entrée d'autorisation qui autorise ou interdit l'application d'impulsions d'incrémentation ou décrémentation au circuit d'intégration, et on s'en servira notamment pour autoriser cette application en mode de veille avec alimentation en tension réduite du circuit intégré (notamment de la mémoire SRAM).

D'autres caractéristiques et avantages de l'invention apparaîtront à la lecture de la description détaillée qui suit et qui est faite en référence aux dessins annexés dans lesquels :
- la figure 1 représente l'architecture générale du circuit de polarisation selon l'invention ;
- la figure 2 représente la constitution du réseau de détection composé de multiples inverseurs en parallèle ;
- la figure 3 représente un étage de conversion de niveau logique (facultatif) en sortie du réseau de détection ;
- la figure 4 représente la constitution de l'amplificateur de détection ;
- la figure 5 représente le circuit de contrôle qui génère quatre signaux impulsionnels complémentaires et qui génère aussi de brèves impulsions d'activation à destination de l'amplificateur de détection ;
- la figure 6 représente le circuit qui produit les brèves impulsions d'activation ;
- la figure 7 représente un circuit translateur de niveau pour transposer les signaux logiques vers une plage de tensions plus élevée ;
- la figure 8 représente un circuit translateur de niveau pour transposer les signaux logiques vers une plage de tensions plus basse ;
- la figure 9 représente une variante de circuit translateur de niveau ;
- la figure 10 représente le circuit d'intégration qui produit les tensions PBIAS et NBIAS à partir des impulsions d'incrémentation ou de décrémentation reçues.

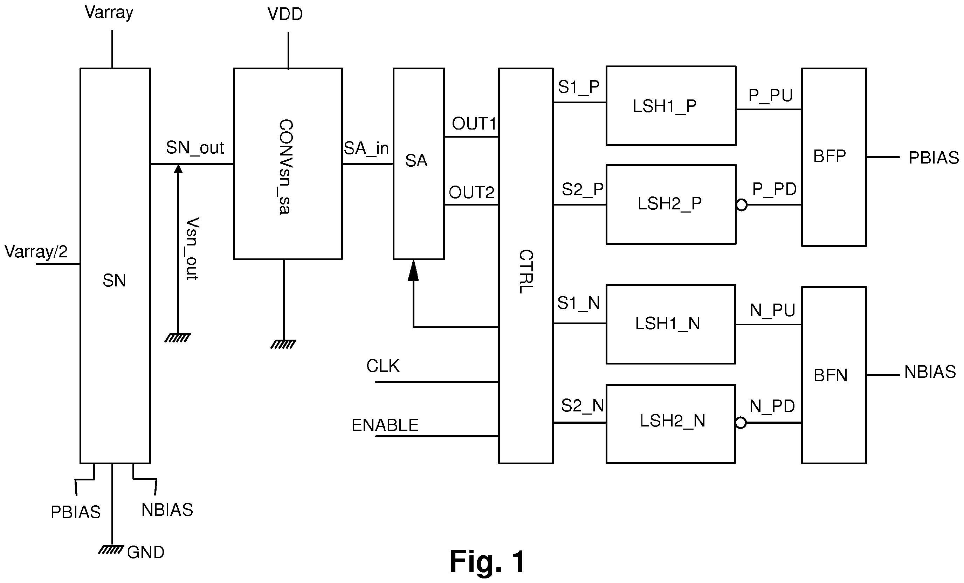

Le schéma de la figure 1 représente le circuit de polarisation selon l'invention qui est associé par exemple à une mémoire SRAM non représentée sur la figure et comprenant une matrice d'éléments de mémorisation binaire, chaque élément de mémorisation comprenant au moins deux inverseurs, et chaque inverseur comprenant un transistor PMOS en série avec un transistor NMOS.

Le circuit de polarisation comporte un réseau de détection SN comprenant de multiples inverseurs en parallèle ; ces inverseurs sont identiques à ceux de la mémoire SRAM ; ils se comportent donc comme ceux de la mémoire en ce qui concerne leur réponse à des changements de tensions de polarisation. Ce réseau de détection fournit sur sa sortie SN_out une valeur de tension Vsn_out qui représente la différence entre les résistances respectives des transistors NMOS et PMOS dans les inverseurs, c'est-à-dire la différence entre les aptitudes de ces transistors à tirer du courant lorsque leur grille reçoit une tension intermédiaire entre une tension de blocage et une tension de mise en conduction. En utilisant de multiples inverseurs, au moins vingt et de préférence cent ou plus), ce réseau donne une indication de la différence de force moyenne entre les transistors PMOS et NMOS ; pour des raisons statistiques, cette différence moyenne représente celle des inverseurs de la mémoire à laquelle ce réseau de détection est associé. Cette différence de force moyenne dépend des tensions de polarisation arrière appliquées aux caissons dans lesquels sont construits les transistors, car ces tensions de polarisation arrière agissent directement sur les tensions de seuil des transistors. Les tensions de polarisation arrière NBIAS et PBIAS qui sont appliquées aux transistors des inverseurs de la mémoire sont également appliquées aux inverseurs du réseau de détection SN afin que le réseau de détection représente fidèlement le comportement des inverseurs de la mémoire. De même, les inverseurs du réseau de détection sont alimentés par la même tension d'alimentation générale Varray qui alimente les points-mémoire de la mémoire SRAM.

On considérera ci-après que l'alimentation se fait entre une tension Varray et une masse GND référencée à 0 volt.

Dans ce qui suit on s'intéresse principalement au cas où la mémoire fonctionne en mode de veille, et la tension Varray est la tension d'alimentation réduite (par rapport à la tension d'alimentation en mode de fonctionnement normal) appliquée au réseau de points mémoire, permettant une minimisation de la consommation tout en assurant une permanence de l'information stockée. Le circuit de polarisation selon l'invention va permettre d'agir sur les tensions de polarisation arrière NBIAS et PBIAS de la mémoire pour à la fois minimiser la consommation et garantir une stabilité suffisante de l'information stockée.

Les inverseurs sont classiquement constitués par un transistor NMOS ayant sa source à la masse, en série avec un transistor PMOS ayant sa source à Varray. Les grilles des deux transistors sont réunies et constituent l'entrée de l'inverseur ; les drains sont réunis et constituent la sortie. Le transistor PMOS est formé dans un caisson de type N auquel on applique une tension de polarisation arrière PBIAS ; le transistor NMOS est formé dans un autre caisson de type P auquel on applique une tension de polarisation arrière NBIAS.

On applique à l'entrée de tous les inverseurs du réseau de détection, sur les grilles réunies des transistors NMOS et PMOS qui constituent ce réseau, une tension commune, intermédiaire entre 0 et Varray, qui va servir à évaluer les forces respectives des transistors NMOS et PMOS. De préférence cette tension de référence est Varray/2. Les inverseurs recevant sur leurs grilles cette tension intermédiaire ont tendance à basculer dans un sens ou dans l'autre selon la force respective du transistor NMOS et du transistor PMOS. Globalement, la tension de sortie du réseau de multiples inverseurs en parallèle tend à prendre une valeur Vsn_out qui découle de cette différence entre les forces des transistors NMOS et PMOS : Vsn_out prend une valeur plus faible (et même proche de 0) si les transistors NMOS sont en moyenne plus forts ; Vsn_out prend une valeur plus forte (et même proche de Varray) si les transistors PMOS sont en moyenne plus forts. Même si les valeurs de Vsn_out ne sont pas exactement 0 et Varray, on considérera que Vsn_out est un signal logique de niveau bas ou de niveau haut selon que Vsn_out est supérieur ou inférieur à Varray/2.

La sortie du réseau de détection SN est appliquée de préférence à un circuit translateur de niveau CONVsn_sa qui convertit le niveau de la tension Vsn_out, qui est dans la gamme de tension de 0 à Varray, en un niveau logique dans une gamme de 0 à VDD, où VDD est la tension d'alimentation générale du circuit intégré. Ce circuit translateur a pour rôle de fournir un signal logique de sortie SA_in qui est égale à zéro ou égale à VDD selon que les transistors NMOS sont en moyenne plus forts ou plus faibles que les transistors PMOS. On reviendra plus loin sur ce circuit translateur CONVsn_sa qui peut être constitué par un simple comparateur à seuil dont le seuil serait fixé entre 0 et Varray (de préférence Varray/2), ou qui peut même être supprimé si la comparaison avec ce seuil est effectuée directement dans l'étage amplificateur qui suit.

La sortie SA_in de ce circuit translateur de niveau est connectée à un amplificateur de détection SA, dont la fonction est de comparer la valeur du signal SA_in à une tension de référence VDD/2 au moment d'un signal d'activation périodique SA_clk de la manière suivante : l'amplificateur SA a deux sorties OUT1 et OUT2 ; pour un état inactif du signal d'activation SA_clk les deux sorties sont pré-chargées à un même niveau ; pour un état actif du signal d'activation, l'une des sorties seulement passera à zéro, selon le niveau du signal d'entrée SA_in. Dans le cas où on ne prévoit pas d'étage translateur de niveau CONVsn_sa, la tension de référence de l'amplificateur SA est Varray/2 plutôt que VDD/2.

Les impulsions d'activation SA_clk sont très brèves, et par conséquent, les impulsions sur la sortie OUT1 ou OUT2 sont très brèves. Leur brièveté permet, comme on le verra, d'ajuster périodiquement les tensions de polarisation PBIAS et NBIAS par tout petits incréments ou décréments afin de garantir la stabilité de la polarisation. De préférence les impulsions sont au moins dix fois plus courtes que la période à laquelle elles sont émises.

L'amplificateur de détection fournit donc, à chaque cycle à la période de l'horloge CLK, une impulsion sur la sortie OUT1 ou sur la sortie OUT2, dépendant du résultat de la comparaison. Une impulsion sur la sortie OUT1 provoquera l'incrémentation des tensions NBIAS et PBIAS. Une impulsion sur la sortie OUT2 provoquera la décrémentation de ces tensions.

Les sorties OUT1 et OUT2 de l'amplificateur SA sont appliquées à un circuit de contrôle CTRL qui reçoit en outre un signal d'autorisation ENABLE et un signal d'horloge CLK. Le circuit de contrôle a deux fonctions : d'abord il établit le signal d'activation SA_clk périodiquement avec une période donnée par l'horloge CLK ; ensuite il établit quatre signaux logiques S1_P, S1_N, S2_P, S2_N à destination de circuits translateurs de niveau ; les deux signaux logiques S1_P et S1_N correspondent au niveau logique OUT1 mais sont légèrement retardés par rapport à OUT1 ; ce sont des impulsions brèves, émises si l'amplificateur de détection SA a fourni une impulsion sur OUT1. De même, les deux signaux logiques S2_P et S2_N correspondent au niveau logique OUT2 mais sont légèrement retardés par rapport à OUT2 ; ce sont des impulsions brèves émises seulement si l'amplificateur de détection a fourni une impulsion sur OUT2. On verra plus loin que les signaux S1_N et S2_P peuvent être inhibés s'il n'y a pas la présence d'une autorisation par un signal ENABLE. Le signal ENABLE est fourni par exemple en même temps qu'un ordre de passage en mode de veille du circuit intégré.

Les impulsions S1_P vont servir à incrémenter la tension de polarisation PBIAS et en même temps les impulsions S1_N vont servir à incrémenter la polarisation NBIAS. Les impulsions S2_P vont servir à décrémenter la polarisation PBIAS et en même temps les impulsions S2_N vont servir à décrémenter la polarisation NBIAS.

Les signaux logiques S1_P, S1_N, S2_P, S2_N en sortie du circuit de contrôle sont dans la plage 0 à VDD. Ils sont transmis respectivement à chacun de quatre circuits translateurs de niveau LSH1_P, LSH1_N, LSH2_P, LSH2_N qui ont les fonctions suivantes : ils décalent le niveau de sortie des signaux S1_P, S1_N, S2_P, S2_N de la plage 0-VDD vers des plages de tension attribuées aux tensions de polarisation arrière PBIAS et NBIAS. Par exemple, la tension de polarisation PBIAS doit pouvoir varier entre Varray et Varray+0,9 volt et la tension de polarisation NBIAS doit pouvoir varier entre 0 et -0,9 volt. Par exemple, si Varray est égal à 0,2 volt, on peut envisager que PBIAS varie entre 0,9 volt et 1,1 volt.

Ainsi, les translateurs de niveau LSH1_P et LSH2_P fournissent des signaux logiques impulsionnels d'incrémentation P_PU et de décrémentation P_PD pour la production de la tension PBIAS ; de même, les translateurs de niveau LSH1_N et LSH2_N fournissent des signaux logiques impulsionnels N_PU et N_PD d'incrémentation et de décrémentation pour la production de la tension NBIAS.

Les signaux P_PU et P_PD varient entre une tension Vlow_P et une tension Vhigh_P, qui sont par exemple respectivement Varray et Varray+0,9volt. Les signaux N_PU et N_PD varient entre une tension Vlow_N et une tension Vhigh_N qui sont par exemple respectivement -0,9 volt et 0 volt.

Ces signaux logiques impulsionnels ainsi translatés sont appliqués à des circuits de sortie BFP et BFN qui fournissent les tensions de polarisation PBIAS et NBIAS. Ces circuits de sortie sont des circuits intégrateurs qui intègrent les petites variations d'incrémentation ou de décrémentation imposées par les impulsions qui leur sont appliquées. Les impulsions P_PU agissent pour incrémenter la tension PBIAS , les impulsions P_PD agissent pour la décrémenter. De même, les signaux N_PU et N_PD agissent l'un pour incrémenter, l'autre pour décrémenter, la tension NBIAS. Les incréments et décréments sont faibles pour assurer une stabilité aux tensions de polarisation.

Un asservissement des tensions PBIAS et NBIAS se produit de ce fait : une variation progressive des tensions de polarisation à la suite des impulsions dans un sens va progressivement augmenter la tension de seuil de l'un des transistors NMOS ou PMOS de la paire constituant un inverseur et diminuer celle de l'autre. Lorsque cette variation sera suffisante, le signal Vsn_out va finir par basculer dans un autre état logique que celui qu'il avait auparavant. Cette modification va inverser les signaux de commande impulsionnels : si les impulsions venaient de la sortie OUT1, elles vont maintenant passer sur la sortie OUT2 où elles agissent en sens contraire (décrémentation au lieu de incrémentation ou le contraire).

On va maintenant décrire le détail des circuits qui composent le schéma de la figure 1. Dans ce qui suit, on donnera les explications en considérant que le circuit à polariser est une mémoire SRAM et que cette mémoire est mise en mode de veille par application d'une tension d'alimentation Varray faible, plus faible que la tension d'alimentation normale VDD de la mémoire, mais qui doit cependant être suffisante pour maintenir l'information stockée, c'est-à-dire pour maintenir les inverseurs dans l'était où ils étaient avant le passage en mode de veille. Mais on remarquera que l'invention permet aussi de gérer la polarisation des inverseurs en mode normal et pas seulement en mode de veille, notamment pour permettre une accélération de l'écriture.

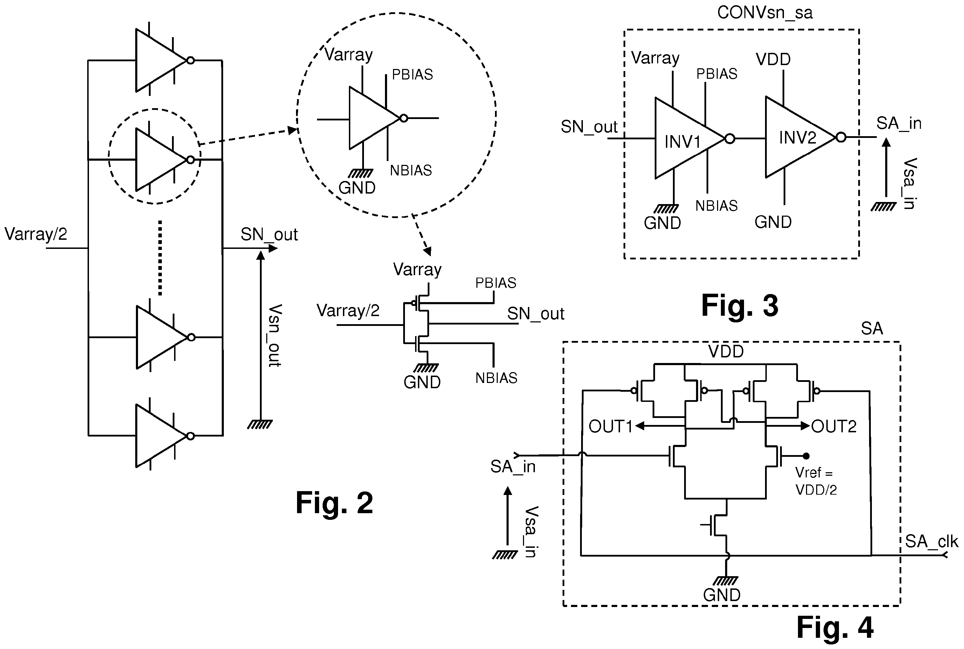

La figure 2 représente le principe du réseau détecteur SN : il comprend de nombreux inverseurs en parallèle, avec toutes leurs entrées réunies en une entrée commune et toutes leurs sorties réunies en une sortie commune SN_out. Les inverseurs sont tous identiques, et identiques aux inverseurs de la mémoire SRAM que le circuit de polarisation est destiné à polariser. Les inverseurs du réseau de détection sont tous polarisés par le circuit de polarisation lui-même dont ce réseau fait partie ; ils sont donc polarisés de la même manière que les autres inverseurs du circuit intégré. La polarisation comprend l'application de quatre potentiels : le potentiel de référence 0 de la masse GND (la référence 0 est une référence arbitraire) appliqué aux sources des transistors NMOS, le potentiel Varray appliqué aux sources des transistors PMOS, la tension de polarisation NBIAS appliquée aux caissons de type P au-dessus desquels ou dans lesquels sont formés les transistors NMOS, et la tension PBIAS appliquée aux caissons de type N au-dessus desquels ou dans lesquels sont formés les transistors PMOS. On rappelle que ces tensions de polarisation influent sur les tensions de seuil des transistors. Elles influent donc sur les conductances respectives du transistor NMOS et du transistor PMOS dans un inverseur, donc sur les risques de basculement intempestif de l'inverseur lorsqu'on place le circuit intégré en mode de veille sous tension d'alimentation Varray réduite. C'est pourquoi il est important de donner à ces tensions de polarisation des valeurs permettant un équilibre des forces des deux transistors de l'inverseur. Cet équilibre est considéré comme atteint lorsque les inverseurs du réseau SN sont en situation proche d'un basculement, c'est-à-dire qu'une faible modification des tensions NBIAS ou PBIAS suffit à faire basculer Vsn_out vers zéro si Vsn_out était proche de Varray ou vers Varray si Vsn_out était proche de zéro.

On notera que l'invention est applicable soit à des technologies dans lesquels les transistors sont formés directement dans des caissons individuels diffusés de type P (transistors NMOS) ou N (transistors PMOS), soit à des technologies dans lesquels les transistors sont formés chacun au-dessus d'un caisson individuel mais séparés de ce caisson par d'autres couches. Dans tous les cas, l'important est que la tension de polarisation du caisson influe sur la tension de seuil du transistor.

Le nombre d'inverseurs du réseau de détection est dicté par des considérations statistiques : il doit être suffisant pour représenter correctement le comportement moyen des inverseurs du circuit intégré à polariser. Un nombre de cent sera en général suffisant. Dans une mémoire SRAM de plusieurs centaines de lignes et colonnes, on pourra utiliser par exemple, pour former le réseau de détection, les inverseurs d'une colonne fictive (en anglais "dummy column") de points mémoire, ces inverseurs étant donc identiques aux inverseurs des véritables points mémoire mais connectés différemment.

La figure 3 représente le circuit translateur de niveau CONVsn_sa dont on rappelle qu'il est facultatif. Il convertit la gamme de tension de 0 à Varray issue du réseau SN en une gamme de 0 à VDD, où VDD est la tension d'alimentation générale du circuit intégré.

Il comprend de préférence d'abord un premier inverseur INV1 polarisé comme les autres par les tensions de polarisation arrière PBIAS et NBIAS, et alimenté entre 0 et Varray. Cet inverseur reçoit la tension Vsn_out ; il est constitué de préférence par des transistors plus gros que les tout petits transistors de la mémoire SRAM. De cette manière ils sont moins sensibles aux dispersions de fabrication classiquement subies par les petits transistors. La géométrie en terme de rapport largeur W sur longueur L du transistor est cependant la même que celle des transistors des inverseurs de la mémoire. A la sortie de cet inverseur INV1, la tension est franchement 0 ou franchement Varray même si la tension Vsn_out a une valeur qui n'est pas exactement l'une de ces deux valeurs.

La sortie de l'inverseur INV1 est reliée à l'entrée d'un deuxième inverseur INV2 qui est alimenté entre 0 et VDD et dont le transistor NMOS est intrinsèquement beaucoup plus fort que le transistor PMOS indépendamment des tensions de polarisation arrière appliquées : le transistor NMOS a un fort rapport W/L, et le transistor PMOS un faible rapport W/L. Le but est d'avoir un point de basculement de l'inverseur pour une tension d'entrée inférieure à Varray, afin que la sortie de cet inverseur représente bien, mais maintenant dans la gamme de tensions 0-VDD, l'état de l'entrée du premier inverseur.

La figure 4 représente un exemple de réalisation de l'amplificateur de détection SA, alimenté entre 0 et VDD. Son entrée SA_in reçoit la tension de sortie Vsa_in du circuit de la figure 3. Il reçoit également une tension de référence Vref et une entrée d'activation périodique SA_clk, et il a deux sorties OUT1 et OUT2. La tension de référence est de préférence VDD/2 ; cependant, si l'étage de la figure 3 était absent, cette tension de référence serait alors Varray/2 (l'amplificateur étant alors alimenté entre 0 et Varray).

L'amplificateur compare l'entrée Vsa_in à la tension de référence Vref à des moments déterminés par le signal d'activation périodique SA_clk. Le signal d'activation SA_clk est un signal périodique qui dépend lui-même des sorties de l'amplificateur ; il est constitué par une impulsion périodique très brève pendant laquelle la comparaison est effectuée.

Si le signal d'activation SA_clk est au niveau bas (inactif), les sorties OUT1 et OUT2 sont toutes deux au même niveau, ici un niveau haut VDD.

Si le signal d'activation est au niveau haut (actif), l'une des sorties change d'état, mais pas l'autre. La sortie qui change d'état dépend du résultat de la comparaison entre Vsa_in et Vref.

Les sorties sont donc identiques lorsque l'horloge est au niveau bas et complémentaires lorsqu'elle est au niveau haut. Dans la configuration représentée à la figure 4, la sortie OUT1 passe au niveau bas lorsque la tension Vsa_in est supérieure à Vref, donc lorsque la tension de sortie Vsn_out du réseau de détection est proche de Varray ; inversement, la sortie OUT2 passe au niveau bas lorsque Vsn_out est proche de zéro.

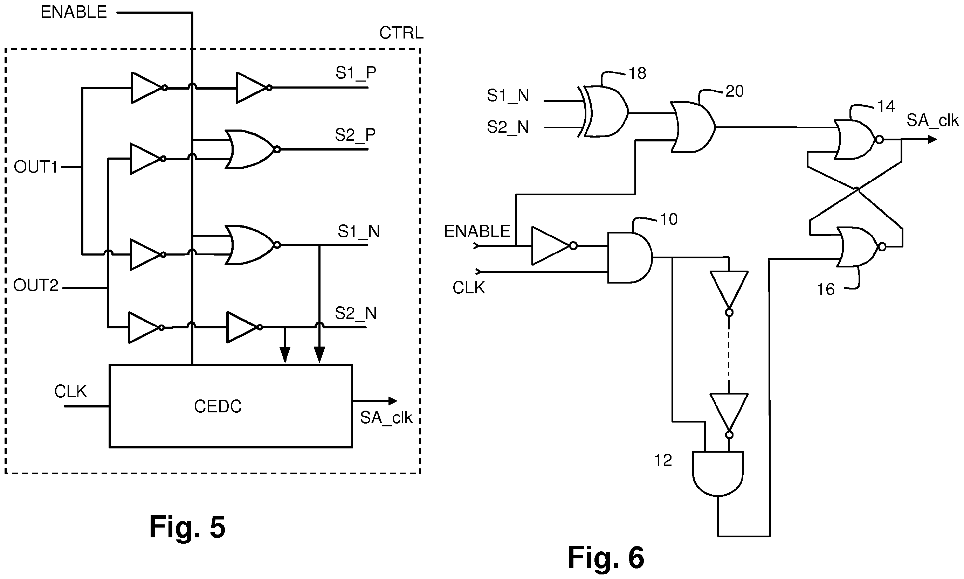

La figure 5 représente le circuit de contrôle CTRL. Ce circuit reçoit un signal d'horloge périodique CLK, un signal d'autorisation ENABLE, et les signaux logiques des sorties OUT1 et OUT2 de l'amplificateur de détection.

Le signal ENABLE peut provenir par exemple d'un ordre de passage en mode de veille.

Le circuit de contrôle comprend des portes logiques qui traitent les signaux OUT1 et OUT2 d'une manière qu'on va indiquer, et un circuit de détection de transitions d'horloge CEDC qui produit le signal d'activation impulsionnel SA_clk à partir du signal d'horloge périodique CLK et à partir des signaux OUT1 et OUT2.

Outre le signal d'activation SA_clk, le circuit de contrôle produit quatre signaux de sortie :
- S1_N et S2_N qui vont servir à la production de la tension de polarisation NBIAS, l'un d'eux servant à incrémenter cette tension, l'autre servant à la décrémenter ;
- et S1_P et S2_P qui vont servir à la production de la tension de polarisation PBIAS, l'un pour l'incrémenter, l'autre pour la décrémenter.

Le signal ENABLE est actif au niveau bas. Il autorise les sorties S1_N et S2_P respectivement à fournir les valeurs logiques présentes sur OUT1 et OUT2. Au niveau haut, le signal ENABLE force à zéro les signaux S1_N et S2_P, la conséquence étant que le circuit de polarisation n'assure plus sa fonction de régulation de NBIAS et PBIAS mais force NBIAS et PBIAS à des valeurs nominales qui sont de préférence zéro pour NBIAS et Varray pour PBIAS.

On s'intéresse ci-après à ce qui se passe lorsque le signal ENABLE est actif.

Les impulsions de passage à zéro de OUT1 sont reportées sur les sorties S1_N et S1_P ; les impulsions OUT2 sont reportées sur les sorties S2_N et S2_P.

Les signaux sur les sorties S1_N et S2_N (ce pourrait être aussi S2_N et S2_P) servent de commande au circuit de détection de transitions d'horloge CEDC. Ce circuit élabore périodiquement une impulsion SA_clk très brève pendant laquelle on effectue la comparaison dans l'amplificateur de détection.

Le circuit CEDC reçoit à cet effet l'horloge périodique CLK dont les créneaux haut et bas sont de durée identique. Il reçoit aussi le signal ENABLE et on considère ici encore le cas où ENABLE est actif (mode de veille), donc au niveau bas. Si ENABLE était au niveau inactif (niveau haut) le circuit ne produirait pas d'impulsions SA_clk.

Le circuit de détection de transition d'horloge est représenté à la figure 6. Une porte ET 10 transmet l'horloge CLK et son complément retardé par un ou plusieurs inverseurs en série aux entrées d'une autre porte ET 12 de manière à produire une impulsion de déclenchement brève sur le front montant du signal d'horloge ; cette impulsion, appliquée à une première entrée d'une bascule RS (constituée par deux portes NI 14 et 16 bouclées l'une sur l'autre), fait basculer la bascule, faisant passer au niveau haut le signal de sortie SA_clk, initialement au niveau bas.

Le processus de comparaison est alors fait dans l'amplificateur de détection pendant cette impulsion brève. L'un des signaux OUT1 ou OUT2 va donc passer à zéro pendant cette impulsion. Les signaux S1_N et S2_N (correspondant aux signaux OUT1 et OUT2 mais légèrement retardés) sont appliqués aux entrées d'une porte OU-Exclusif 18 qui fournit un signal logique en général nul quand S1_N et S2_N sont tous deux au niveau 1 et qui fournit un signal logique haut quand l'un ou l'autre de OUT1 et OUT2 passe à zéro.

Le passage au niveau haut de la sortie de la porte 18 fait à nouveau basculer la bascule 14, 16 qui ramène à zéro le signal SA_clk, interrompant le signal d'activation qui est donc très bref. Le signal OUT1 ou OUT2 qui était passé au niveau bas revient au niveau haut que lui impose l'interruption du signal d'activation ; les signaux S1_N, S1_P, S2_N, S2_P reviennent à nouveau tous au niveau haut.

Le résultat est qu'on a périodiquement une impulsion brève soit sur la sortie S1_N et la sortie S1_P soit sur la sortie S2_N et la sortie S2_P, selon qu'il faut incrémenter ou décrémenter les tensions de polarisation PBIAS et NBIAS.

Une porte OU 20 reçoit le signal ENABLE pour bloquer la bascule avec SA_clk au niveau bas lorsque ENABLE est au niveau inactif (niveau haut) pour interdire l'asservissement des tensions de polarisation.

L'impulsion sert, à la manière d'une pompe de charge, à incrémenter ou décrémenter la tension moyenne PBIAS ou NBIAS par injection d'un courant de charge ou décharge bref pendant la durée de l'impulsion. C'est la capacité naturelle globale des régions polarisées par les tensions PBIAS et NBIAS qui maintient la tension de polarisation à une valeur moyenne entre deux impulsions.

Mais les signaux S1_N, S1_P, S2_N, S2_P sont entre 0 (niveau bas) et VDD (niveau haut). Il faut les ramener à une plage de tension correspondant à la plage de tension dans laquelle peuvent évoluer les tensions NBIAS et PBIAS.

Par exemple, la tension Varray est de 0,2 volt et on souhaite que les tensions de polarisation arrière puissent varier entre 0 volt et -0,9 volt pour NBIAS et entre 0,2 volt et 1,1 volt pour PBIAS.

C'est la raison de la présence des translateurs de niveau LSH1_P, LSH2_P, LSH1_N, LSH2_N sur la figure 1.

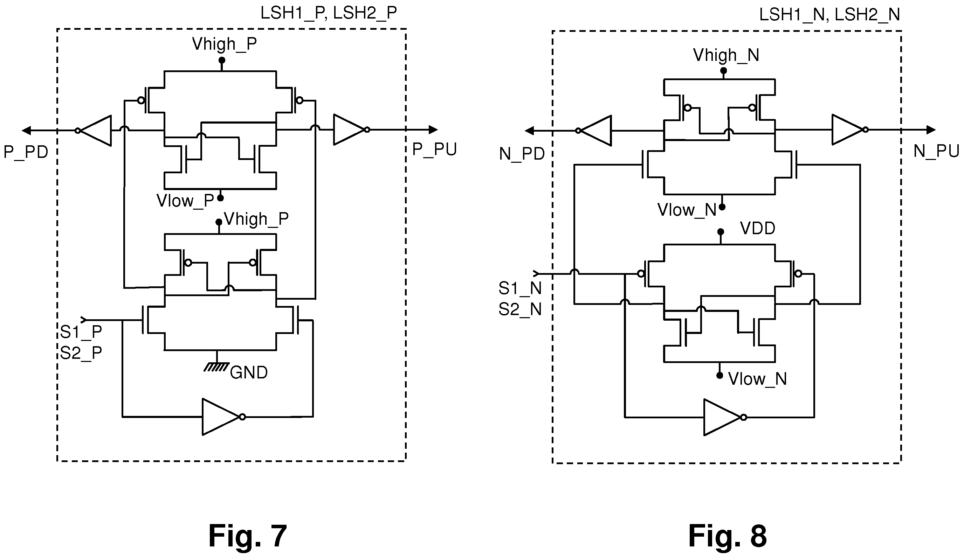

La figure 7 représente la configuration d'un translateur de niveau LSH1_P qui peut être utilisé pour une translation vers des potentiels supérieurs. Il reçoit l'impulsion S1_P et fournit une impulsion P_PU sur une de ses sorties ; l'impulsion P_PU est une impulsion d'incrémentation de la tension PBIAS et ce doit être, comme on le verra, une impulsion de passage au niveau logique bas car elle commande un transistor PMOS. Le circuit LSH1_P possède une deuxième sortie référencée P_PD, complément logique de la première, mais qui n'est pas utilisée. Le translateur de niveau LSH2_P est rigoureusement identique mais il reçoit l'impulsion S2_P et il utilise la deuxième sortie P_PD et non la première ; en effet, il doit produire une impulsion de décrémentation de la tension PBIAS et cette impulsion doit être une impulsion de passage au niveau logique haut car elle commande un transistor NMOS.

Sur ce schéma on a appelé Vhigh_P et Vlow_P des sources de tension permettant la transposition des niveaux d'impulsions vers la plage de tension de Vlow_P à Vhigh_P. Le potentiel de référence zéro est utilisé dans ce schéma. Vlow_P est en principe égal à Varray ; Vhigh_P peut être égal à Varray+0,9 volt.

De même, la figure 8 représente un translateur de niveau LSH1_N pour une translation vers des potentiels inférieurs. Il reçoit l'impulsion S1_N et fournit une impulsion N_PU sur une de ses sorties (impulsion de passage au niveau bas pour la commande d'un transistor PMOS d'incrémentation de NBIAS) ; il possède une sortie logique complémentaire N_PD qui n'est pas utilisée. Le translateur LSH2_N est identique, il reçoit l'impulsion S2_N et il fournit une impulsion sur la deuxième sortie N_PD et non la première (impulsion de passage au niveau haut pour la commande d'un transistor NMOS de décrémentation de NBIAS). Ces deux translateurs de niveau sont alimentés par des tensions Vhigh_N et Vlow_N ainsi que par le potentiel VDD utilisé dans les étages précédents. Vhigh_N est en principe égal à 0 ; Vlow_N peut être égal à -0,9 volt.

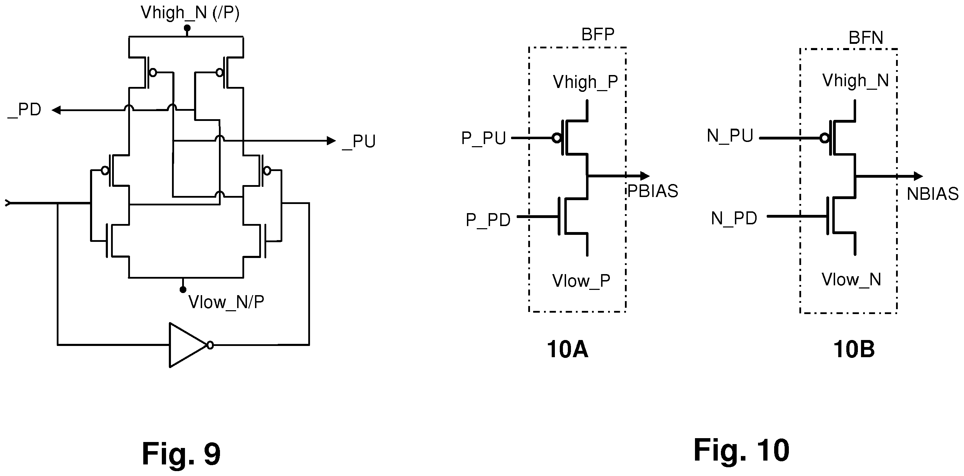

La figure 9 représente un autre exemple de circuit translateur de niveau, pouvant servir aussi bien pour une translation de niveau vers le haut que pour une translation de niveau vers le bas.

Enfin, la figure 10 représente les deux étages intégrateurs de sortie BFP et BFN fournissant les tensions PBIAS et NBIAS. Ce sont des étages comprenant chacun un transistor NMOS en série avec un transistor PMOS. Ces ensembles en série sont alimentés par les potentiels Vhigh_P et Vlow_P pour l'étage fournissant le potentiel PBIAS (figure 10A) ou par les potentiels Vhigh_N et Vlow_N pour l'étage fournissant le potentiel NBIAS (figure 10B).

Les impulsions des sorties P_PU et P_PD des translateurs de niveau sont appliquées respectivement à la grille du transistor PMOS et à la grille du transistor NMOS pour l'étage qui fournit la tension de polarisation PBIAS. Les niveaux logiques N_PU et N_PD sont appliqués aux grilles des transistors de l'étage qui fournit la tension de polarisation PBIAS.

L'impulsion P_PU (incrémentation de PBIAS) est une impulsion de passage à zéro (Vlow_P) et rend brièvement conducteur le transistor PMOS.

L'impulsion P_PD (décrémentation de PBIAS) est une impulsion de passage au niveau haut (Vhigh_P) et rend brièvement conducteur le transistor NMOS.

L'impulsion N_PU (incrémentation de NBIAS) est une impulsion de passage au niveau haut (Vhigh_N) et rend brièvement conducteur le transistor PMOS.

L'impulsion N_PD (décrémentation de NBIAS) est une impulsion de passage au niveau bas (Vlow_N) et rend brièvement conducteur le transistor NMOS.

## Revendications

1. Circuit de polarisation d'inverseurs d'un circuit intégré, chaque inverseur comprenant un transistor NMOS et un transistor PMOS alimentés par une tension d'alimentation Varray, avec des moyens pour appliquer une première tension de polarisation arrière (NBIAS) aux caissons des transistors NMOS et une deuxième tension de polarisation arrière (PBIAS) aux caissons des transistors PMOS, le circuit de polarisation selon l'invention fournissant ces tensions de polarisation et comprenant :
- un réseau de détection (SN) comprenant une pluralité d'inverseurs montés en parallèle, les inverseurs étant alimentés par la tension d'alimentation Varray et polarisés par les deux tensions de polarisation arrière et recevant sur leur grilles une même tension de référence comprise entre 0 et la tension d'alimentation Varray des inverseurs, la sortie commune des inverseurs constituant la sortie (SN_out) du réseau de détection, cette sortie fournissant un signal logique dont la valeur dépend des tensions de polarisation arrière appliquées au réseau,
- un circuit (CTRL, SA) de production d'impulsions d'incrémentation ou décrémentation, commandé par la sortie du réseau de détection,
- et un circuit d'intégration (BFP, BFN) relié au circuit de production d'impulsions, pour produire et faire varier progressivement par incréments en réponse à ces impulsions, la première tension de polarisation arrière (NBIAS) et la deuxième tension de polarisation arrière (PBIAS) dans un sens tendant à inverser le signal logique de sortie du réseau de détecteur.

2. Circuit de polarisation selon la revendication 1, **caractérisé en ce que** la tension de référence appliquée aux grilles des transistors des inverseurs du réseau de détection est Varray/2.

3. Circuit de polarisation selon l'une des revendications 1 et 2, **caractérisé en ce qu'**un circuit de translation de niveau logique (CONVsn_sa) est interposé entre la sortie du réseau de détection et l'entrée du circuit de production d'impulsions.

4. Circuit de polarisation selon l'une des revendications 1 à 3, **caractérisé en ce que** le circuit de production d'impulsions comprend un amplificateur de détection (SA) et un circuit de contrôle (CTRL), le circuit de contrôle comportant un circuit d'horloge (CEDC) produisant périodiquement un signal d'activation constitué par des impulsions brèves qui sont des impulsions d'activation de l'amplificateur de détection, l'amplificateur de détection recevant une tension issue du réseau de détection et agissant comme un comparateur par rapport à une tension de référence pour produire sur l'une de deux sorties (OUT1, OUT2), en fonction du résultat de la comparaison, une impulsion de commande.

5. Circuit de polarisation selon la revendication 4, **caractérisé en ce que** le circuit de contrôle reçoit les deux sorties de l'amplificateur de détection et produit quatre signaux logiques impulsionnels correspondants, en fonction des résultats de la comparaison, transmis respectivement à quatre circuits translateurs de niveau, deux premiers circuits translateurs de niveau convertissant deux des signaux dans une plage de tension correspondant à une plage de variation de tension désirée pour la deuxième tension de polarisation arrière (PBIAS), et deux autres circuits translateurs de niveau convertissant les deux autres signaux dans une plage de tensions correspondant à une plage de variation de tension désirée pour la première tension de polarisation arrière (NBIAS).

6. Circuit de polarisation selon la revendication 5, **caractérisé en ce que** le circuit d'intégration (BFP, BFN) comprend un premier circuit pour produire la deuxième tension de polarisation arrière (PBIAS) et un deuxième circuit pour produire la première tension de polarisation arrière (NBIAS) le premier circuit recevant sur ses entrées les sorties de deux premiers circuits translateurs de niveau, et le deuxième circuit recevant sur ses entrées les sorties des deux autres circuits translateurs de niveau.

7. Circuit de polarisation selon la revendication 6, **caractérisé en ce que** le premier et le deuxième circuits comprennent chacun un transistor PMOS en série avec un transistor NMOS, fournissant la deuxième tension de polarisation (PBIAS) ou respectivement la première tension de polarisation (NBIAS) au point de jonction de ces deux transisors, les sorties des circuits translateurs de niveau étant appliquées aux grilles de ces transistors, l'ensemble de transistors en série du premier circuit étant alimenté entre une tension basse (Vlow_P) et une tension haute (Vhigh_P) correspondant à la plage de tensions désirée pour la variation de la deuxième tension de polarisation (PBIAS), et l'ensemble de transistors en série du deuxième circuit étant alimenté entre une tension basse (Vlow_N) et une tension haute (Vhigh_N) correspondant à la plage de tensions désirée pour la variation de la première tension de polarisation (NBIAS).

8. Circuit de polarisation selon l'une des revendications 1 à 7, **caractérisé en ce qu'**il fournit les deuxième et première tensions de polarisation arrière (PBIAS, NBIAS) aux transistors PMOS et NMOS des inverseurs d'une mémoire SRAM.

9. Circuit de polarisation selon la revendication 8, **caractérisé en ce qu'**il comporte une entrée d'autorisation (ENABLE) qui autorise ou interdit l'application d'impulsions d'incrémentation ou décrémentation au circuit d'intégration, notamment pour autoriser cette application en mode de veille avec alimentation en tension réduite de la mémoire.

10. Circuit de polarisation selon l'une des revendications 1 à 9, **caractérisé en ce qu'**il comporte des moyens pour appliquer aux inverseurs en mode de veille la tension d'alimentation Varray réduite par rapport à une tension d'alimentation générale (VDD) du circuit intégré.

11. Circuit intégré comportant une mémoire SRAM constituée d'une matrice d'éléments de mémorisation binaire et un circuit de polarisation selon l'une des revendications 1 à 10, **caractérisé en ce que** chaque élément de mémorisation comprend au moins deux inverseurs identiques aux inverseurs du réseau de détection.

## Patentansprüche

1. Invertervorspannungsschaltung einer integrierten Schaltung, wobei jeder Inverter einen NMOS-Transistor und einen PMOS-Transistor umfasst, die mit einer Speisespannung Varray gespeist werden, mit Mitteln zum Anlegen einer ersten Rückwärtsvorspannung (NBAS) an die NMOS-Transistoren und einer zweiten Rückwärtsvorspannung (PBIAS) an die PMOS-Transistoren, wobei die erfindungsgemäße Vorspannungsschaltung diese Vorspannungen liefert und Folgendes umfasst:
- ein Erkennungsnetz (SN), das mehrere parallel geschaltete Inverter umfasst, wobei die Inverter von der Speisespannung Varray gespeist und mit den beiden Rückwärtsvorspannungen vorgespannt werden und an ihrem Gate eine selbe Referenzspannung zwischen 0 und der Speisespannung Varray der Inverter empfangen, wobei der gemeinsame Ausgang der Inverter den Ausgang (SN_out) des Erkennungsnetzes bildet, wobei dieser Ausgang ein Logiksignal liefert, dessen Wert von von den an das Netzwerk angelegten Rückwärtsvorspannungen abhängig ist,
- eine Inkrementier- oder Dekrementierimpulserzeugungsschaltung (CTRL, SA), gesteuert durch den Ausgang des Erkennungsnetzes,
- und eine Integrationsschaltung (BSP, BSN), verbunden mit der Impulserzeugungsschaltung, zum Erzeugen und progressiven inkrementalen Variieren, als Reaktion auf diese Impulse, der ersten Rückwärtsvorspannung (NBIAS) und der zweiten Rückwärtsvorspannung (PBIAS) in einer Richtung, die dazu neigt, das Ausgangslogiksignal des Erkennungsnetzes umzukehren.

2. Vorspannungsschaltung nach Anspruch 1, **dadurch gekennzeichnet, dass** die an die Gates der Transistoren der Inverter des Erkennungsnetzes angelegte Referenzspannung Varray/2 ist.

3. Vorspannungsschaltung nach einem der Ansprüche 1 und 2, **dadurch gekennzeichnet, dass** eine Logikpegelumsetzschaltung (CONVsn_sa) zwischen den Ausgang des Erkennungsnetzes und den Eingang der Impulserzeugungsschaltung geschaltet ist.

4. Vorspannungsschaltung nach einem der Ansprüche 1 bis 3, **dadurch gekennzeichnet, dass** die Impulserzeugungsschaltung einen Erkennungsverstärker (SA) und eine Steuerschaltung (CTRL) umfasst, wobei die Steuerschaltung eine Taktschaltung (CEDC) umfasst, die periodisch ein Aktivierungssignal erzeugt, das von kurzen Impulsen gebildet wird, die Aktivierungsimpulse des Erkennungsverstärkers sind, wobei der Erkennungsverstärker eine vom Erkennungsnetz kommende Spannung empfängt und als Komparator mit Bezug auf eine Referenzspannung agiert, um an einem von zwei Ausgängen (OUT1, OUT2) einen Steuerimpuls in Abhängigkeit vom Ergebnis des Vergleichs zu erzeugen.

5. Vorspannungsschaltung nach Anspruch 4, **dadurch gekennzeichnet, dass** die Steuerspannung die beiden Ausgänge des Erkennungsverstärkers empfängt und vier entsprechende Impulslogiksignale erzeugt, in Abhängigkeit von den Ergebnissen des Vergleichs, jeweils gesendet zu vier Pegelumsetzschaltungen, wobei zwei erste Pegelumsetzschaltungen zwei der Signale in einen Spannungsbereich entsprechend einem gewünschten Spannungsvariationsbereich für die zweite Rückwärtsvorspannung (PBIAS) umwandelt, und wobei zwei andere Pegelumsetzschaltungen die beiden anderen Signale in einen Spannungsbereich entsprechend einem gewünschten Spannungsvariationsbereich für die erste Rückwärtsvorspannung (NBIAS) umwandeln.

6. Vorspannungsschaltung nach Anspruch 5, **dadurch gekennzeichnet, dass** die Integrationsschaltung (BFP, BSN) eine erste Schaltung zum Erzeugen der zweiten Rückwärtsvorspannung (PBIAS) und eine zweite Schaltung zum Erzeugen der ersten Rückwärtsvorspannung (NBIAS) umfasst, wobei die erste Schaltung an ihren Eingängen die Ausgänge von zwei ersten Pegelumsetzschaltungen empfängt und die zweite Schaltung an ihren Eingängen die Ausgänge der beiden anderen Pegelumsetzschaltungen empfängt.

7. Vorspannungsschaltung nach Anspruch 6, **dadurch gekennzeichnet, dass** die erste und die zweite Schaltung jeweils einen PMOS-Transistor in Serie mit einem NMOS-Transistor umfassen, die die zweite Vorspannung (PPIAS) bzw. die erste Vorspannung (NBIAS) am Übergangspunkt dieser beiden Transistoren liefern, wobei die Ausgänge der Pegelumsetzschaltungen an die Gates dieser Transistoren angelegt werden, wobei alle Transistoren in Serie von der ersten Schaltung mit einer Spannung zwischen einer tiefen Spannung (Vlow_P) und einer hohen Spannung (Vhigh_P) entsprechend dem gewünschten Spannungsbereich für die Variation der zweiten Vorspannung (PBIAS) gespeist werden und wobei alle Transistoren in Serie von der zweiten Schaltung mit einer Spannung zwischen einer tiefen Spannung (Vlow_N) und einer hohen Spannung (Vhigh_N) entsprechend dem gewünschten Spannungsbereich für die Variation der ersten Vorspannung (NBIAS) gespeist werden.

8. Vorspannungsschaltung nach einem der Ansprüche 1 bis 7, **dadurch gekennzeichnet, dass** sie die zweite und erste Rückwärtsvorspannung (PBIAS, NBIAS) an die PMOS- und NMOS-Transistoren der Inverter eines SRAM anlegt.

9. Vorspannungsschaltung nach Anspruch 8, **dadurch gekennzeichnet, dass** sie einen Autorisierungseingang (ENABLE) umfasst, der das Anlegen von Inkrementier- oder Dekrementierimpulsen an die Integrationsschaltung zulässt oder nicht zulässt, insbesondere zum Autorisieren dieses Anlegens im Standby-Modus mit reduzierter Spannungsspeisung des Speichers.

10. Vorspannungsschaltung nach einem der Ansprüche 1 bis 9, **dadurch gekennzeichnet, dass** sie Mittel zum Anlegen der mit Bezug auf eine allgemeine Speisespannung (VDD) der integrierten Schaltung reduzierten Speisespannung Varray an die Inverter im Standby-Modus umfasst.

11. Integrierte Schaltung, die einen SRAM umfasst, gebildet von einer Matrix von binären Speicherelementen und einer Vorspannungsschaltung nach einem der Ansprüche 1 bis 10, **dadurch gekennzeichnet, dass** jedes Speicherelement wenigstens zwei mit den Invertern des Erkennungsnetzes identische Inverter umfasst.

## Claims

1. Bias circuit for inverters of an integrated circuit, each inverter comprising an NMOS transistor and a PMOS transistor powered by a power supply voltage Varray, with means for applying a first rear bias voltage (NBIAS) to the wells of the NMOS transistors and a second rear bias voltage (PBIAS) to the wells of the PMOS transistors, the bias circuit according to the invention supplying these bias voltages and comprising:
- a detection array (SN) comprising a plurality of inverters mounted in parallel, the inverters being powered by the power supply voltage Varray and biased by the two rear bias voltages and receiving on the gates thereof the same reference voltage between 0 and the power supply voltage Varray of the inverters, the common output of the inverters forming the output (SN_out) of the detection array, this output providing a logic signal whose value depends on the rear bias voltages applied to the array,
- a circuit (CTRL, SA) for producing incrementation or decrementation pulses, controlled by the output of the detection array,
- and an integration circuit (BFP, BFN) connected to the pulse-producing circuit in order to produce and vary, progressively by increments in response to these pulses, the first rear bias voltage (NBIAS) and the second rear bias voltage (PBIAS) in a direction tending to invert the output logic signal of the detector array.

2. Bias circuit according to claim 1, **characterised in that** the reference voltage applied to the gates of the transistors of the inverters of the detection array is Varray/2.

3. Bias circuit according to either claim 1 or claim 2, **characterised in that** a logic level translation circuit (CONVsn_sa) is interposed between the output of the detection array and the input of the pulse-producing circuit.

4. Bias circuit according to any one of claims 1 to 3, **characterised in that** the pulse-producing circuit comprises a detection amplifier (SA) and a control circuit (CTRL), the control circuit comprising a clock circuit (CEDC) periodically producing an activation signal constituted by brief pulses which are activation pulses of the detection amplifier, the detection amplifier receiving a voltage from the detection array and acting as a comparator relative to a reference voltage in order to produce a control pulse on one of two outputs (OUT1, OUT2) in accordance with the result of the comparison.

5. Bias circuit according to claim 4, **characterised in that** the control circuit receives the two outputs of the detection amplifier and produces four corresponding pulsed logic signals, in accordance with the results of the comparison, which are transmitted to four level translation circuits, respectively, two first level translation circuits converting two of the signals into a voltage range corresponding to a voltage variation range desired for the second rear bias voltage (PBIAS), and two other level translation circuits converting the other two signals into a voltage range corresponding to a voltage variation range desired for the first rear bias voltage (NBIAS).

6. Bias circuit according to claim 5, **characterised in that** the integration circuit (BFP, BFN) comprises a first circuit for producing the second rear bias voltage (PBIAS) and a second circuit for producing the first rear bias voltage (NBIAS), the first circuit receiving on the inputs thereof the outputs of two first level translation circuits, and the second circuit receiving on the inputs thereof the outputs of the other two level translation circuits.

7. Bias circuit according to claim 6, **characterised in that** the first and the second circuits each comprise a PMOS transistor in series with an NMOS transistor, supplying the second bias voltage (PBIAS) or the first bias voltage (NBIAS) at the junction point of these two transistors, respectively, the outputs of the level translation circuits being applied to the gates of these transistors, the set of series transistors of the first circuit being powered between a low voltage (Vlow_P) and a high voltage (Vhigh_P) corresponding to the desired voltage range for the variation of the second bias voltage (PBIAS), and the set of series transistors of the second circuit being powered between a low voltage (Vlow_N) and a high voltage (Vhigh_N) corresponding to the desired voltage range for the variation of the first bias voltage (NBIAS).

8. Bias circuit according to any one of claims 1 to 7, **characterised in that** it supplies the second and first rear bias voltages (PBIAS, NBIAS) to the PMOS and NMOS transistors of the inverters of an SRAM memory.

9. Bias circuit according to claim 8, **characterised in that** it comprises an enable input (ENABLE) which enables or disables the application of incrementation or decrementation pulses to the integration circuit, in particular in order to enable this application in standby mode with reduced voltage power supply for the memory.

10. Bias circuit according to any one of claims 1 to 9, **characterised in that** it comprises means for applying, to the inverters in standby mode, the reduced power supply voltage Varray compared with a general power supply voltage (VDD) of the integrated circuit.

11. Integrated circuit comprising an SRAM memory constituted by a matrix of binary storage elements and a bias circuit according to any one of claims 1 to 10, **characterised in that** each storage element comprises at least two inverters identical to the inverters of the detection array.
